(19) Europäisches Patentamt
European Patent Office
Office européen des brevets

(11) **EP 4 640 916 A1**

(12) **EUROPEAN PATENT APPLICATION**

(43) Date of publication:
**29.10.2025   Bulletin 2025/44**

(21) Application number: **24171584.6**

(22) Date of filing: **22.04.2024**

(51) International Patent Classification (IPC):
*C23C 14/00* [(2006.01)]   *C23C 14/06* [(2006.01)]
*C23C 14/14* [(2006.01)]   *C23C 16/00* [(2006.01)]
*C23C 16/06* [(2006.01)]   *C23C 16/30* [(2006.01)]
*C23C 28/02* [(2006.01)]   *C23C 28/04* [(2006.01)]
*C23C 28/00* [(2006.01)]

(52) Cooperative Patent Classification (CPC):
**C23C 14/0015; C23C 14/0641; C23C 14/0676;
C23C 14/14; C23C 16/006; C23C 16/06;
C23C 16/303; C23C 16/308; C23C 28/023;
C23C 28/042; C23C 28/044; C23C 28/322;
C23C 28/34**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **IHI Ionbond AG
4657 Dulliken (CH)**

(72) Inventors:
• **DIELIS, Ron**
  **4657 Dulliken (CH)**
• **ENGELS, Martin**
  **4657 Dulliken (CH)**
• **HURKMANS, Ton**
  **4657 Dulliken (CH)**
• **JANIK, Robert**
  **4657 Dulliken (CH)**

(74) Representative: **Hoffmann Eitle
Patent- und Rechtsanwälte PartmbB
Arabellastraße 30
81925 München (DE)**

(54) **COATING FOR A SUBSTRATE; SUBSTRATE; AND ARTICLE**

(57)     The present disclosure relates to a coating for a substrate, the coating comprising: a first vapor phase deposition layer for depositing on the substrate, wherein the first vapor phase deposition layer reflects light having a first color; and a second vapor phase deposition layer deposited on the first vapor phase deposition layer, wherein the second vapor phase deposition layer reflects light having a second color different from the first color; wherein a thickness of the second vapor phase deposition layer is adjusted such that the coating reflects light having a third color different from the first color and the second color.

Fig. 1

EP 4 640 916 A1

## Description

TECHNICAL FIELD

The present disclosure relates to a coating for a substrate, a substrate having the coating, and an article comprising the substrate.

BACKGROUND

Coating of a substrate is a manufacturing processes used to apply a bonded layer of amorphous material to a surface of the substrate. The manufacturing process and the applied layer itself are both referred to as coating. Depending on the manufacturing process and/or an application purpose, the coating may comprise a thin layer, a thick layer, or several contiguous layers. Typically, coating processes are categorized into chemical, mechanical, thermal and thermomechanical processes depending on the application purpose of the coating.

The substrate refers to a carrier material having a surface on which the coating is to be provided. The carrier material may be another coating or solid substances such as metals, insulators, semiconductors, crystalline or amorphous materials, textile fabrics (e.g. woven, non-woven, knitted fabrics), films and the like. In order to ensure good bonding of the coating to the substrate, the substrate may be subjected to a surface pre-treatment such as grinding, micro-blasting, etching, electroplating, silanizing, nitriding, and the like.

As an example, an application purpose of the coating may be to protect the underlying substrate from external effects such as abrasion (e.g. by tribological stress), discoloration (e.g. by ultraviolet radiation), corrosion (e.g. by chemical oxidation reactions), and the like. As another example, an application purpose of the coating may be to change a visual appearance of the substrate such as changing a color and/or texture of the substrate.

Reference documents [1] - [11] disclose various techniques for manufacturing a coating of a substrate in order to achieve a desired visual appearance of the substrate.

REFERENCE DOCUMENTS

[1]: Tarek, Ahmad HJ, et al. "Physical Vapour Deposition of Zr-Based Nano Films on Various Substrates: A Review." Current Nanoscience 18.3 (2022): 347-366

[2] : Kuprin, Alexander S., et al. "Structure and properties of ZrON coatings synthesized by cathodic arc evaporation." Materials 14.6 (2021): 1483

[3]: Perkins, Joshua, et al. "Color Tunable, Lithography-Free Refractory Metal-Oxide Metacoatings with a Graded Refractive Index Profile." Nano Letters 23.7 (2023): 2601-2606.

[4] : CN 217651304 U

[5]: CN 106381473 A

[6]: CN 102114720 A

[7]: CN 1502430 A

[8]: US 6,586,114 B1

[9]: EP 0 890 659 A2

[10]: WO 2014/116967 A1

[11]: Final Report Summary - NANO4COLOR (Design and develop a new generation of color PVD coatings for decorative applications): FP7: CORDIS: European Commission. https://cordis.europa.eu/project/id/315286/reporting (last accesses February 16, 2024)

SUMMARY

However, common vacuum deposited coatings for substrates are typically limited in the number of possible colors they can provide. As an example, common coatings applied by vapor phase deposition techniques are only able to provide colors such as gold, brass, black, rose gold, chrome, blue and silver. Thus, there is a need for a coating that is able to provide a wider variety of colors.

One embodiment relates to a coating for a substrate, the coating comprising a first vapor phase deposition layer for depositing on the substrate, wherein the first vapor phase deposition layer reflects light having a first color. The coating further comprises a second vapor phase deposition layer deposited on the first vapor phase deposition layer, wherein the second vapor phase deposition layer reflects light having a second color different from the first color. A thickness of the second vapor phase deposition layer is adjusted such that the coating reflects light having a third color different from the first color and the second color.

Another embodiment relates to a substrate having a coating according to an embodiment. Yet another embodiment relates to an article comprising a substrate according to an embodiment.

Further preferred embodiments are defined in the dependent claims.

The coating according to an embodiment is able to provide a wide variety of colors.

BRIEF DESCRIPTION OF THE DRAWINGS

Embodiments of the present disclosure, which are presented for better understanding the inventive concepts, but which are not to be seen as limiting the invention, will now be described with reference to the figures in which:

Fig. 1 shows a sideview of an example for a coating for a substrate according to an embodiment;

Fig. 2A shows an example of a coating comprising a reflective first vapor phase deposition layer and an at least semi-transparent second vapor phase deposition layer;

Fig. 2B shows an example of a coating comprising an at least semi-transparent first vapor phase deposition layer and an at least semi-transparent second vapor phase deposition layer;

Fig. 2C shows an example of a coating comprising a reflective first vapor phase deposition layer and a reflective second vapor phase deposition layer provided as a sparse layer;

Fig. 2D shows an example of a coating comprising an at least semi-transparent first vapor phase deposition layer and a reflective second vapor phase deposition layer provided as a sparse layer; and

Fig. 3 shows an example of subtractive color mixing using substrates made from a metal.

DETAILED DESCRIPTION

The present disclosure shall now be described in conjunction with specific embodiments. The specific embodiments serve to provide the skilled person with a better understanding but are not intended to in any way restrict the scope of the present disclosure, which is defined by the appended claims. In particular, the embodiments described independently throughout the description can be combined to form further embodiments to the extent that they are not mutually exclusive.

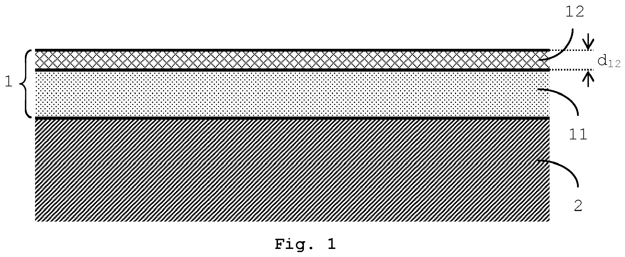

Fig. 1 shows a sideview of an example for a coating 1 for a substrate 2 according to an embodiment. The coating 1 comprises a first vapor phase deposition layer 11 for depositing on the substrate, wherein the first vapor phase deposition layer 11 reflects light having a first color. The coating further comprises a second vapor phase deposition layer 12 deposited on the first vapor phase deposition layer 11, wherein the second vapor phase deposition layer 12 reflects light having a second color different from the first color. A thickness $d_{12}$ of the second vapor phase deposition layer 12 is adjusted such that the coating 1 reflects light having a third color different from the first color and the second color.

The substrate 2 refers to a carrier material having a surface on which the coating 1 is to be provided. The carrier material may be another coating or solid substances such as metals, insulators, semiconductors, crystalline or amorphous materials, textile fabrics (e.g. woven, non-woven, knitted fabrics), films and the like. In order to ensure good bonding of the coating 1 to the substrate 2, the substrate 2 may be subjected to a surface pre-treatment such as grinding, micro-blasting, etching, electroplating, silanizing, nitriding, and the like.

The term "deposit on" does not mean that the deposition must be in direct contact with the surface on which it is deposited. In other words, a first vapor phase deposition layer may be considered as being deposited on a substrate not only when it is directly deposited on the substrate but also in case another layer is located between the substrate and the first vapor phase deposition layer. Similarly, a second vapor phase deposition layer may be considered as being deposited on the first vapor phase deposition layer also in case another layer, in particular a layer not interfering with the generation of the third color, such as a colorless (i.e. transparent) layer is located between the first and the second vapor phase deposition layer. As an example, the another layer may be an adhesion layer, a corrosion resistance layer, a wear resistance layer, or the like.

A vapor phase deposition layer may be manufactured by any one of a physical vapor deposition (PVD) process, a chemical vapor deposition process (CVD), and a plasma-enhanced chemical vapor deposition (PECVD) process. Different manufacturing processes may be used for each of the first vapor phase deposition layer 11 and the second vapor phase deposition layer 12. In each of these manufacturing processes, a vapor phase deposition layer is deposited on an underlying surface (e.g. the substrate or another vapor phase deposition layer) such that it is in direct contact with the underlying surface.

In a PVD process, a solid material is vaporized, can be ionized, and deposited onto a surface of a substrate. The vapor phase deposition layers may for instance be deposited using magnetron sputtering or cathodic arc evaporation as a PVD process. In a CVD process, a substrate arranged in a vacuum chamber is exposed to one or more volatile compounds, which react or decompose on a surface of the substrate to produce the desired deposit. In a PECVD process, a CVD process is carried out in which chemical reactions are involved which occur after creation and use of a plasma of reacting gases.

A thickness of a vapor phase deposition layer may be measured in a direction that is perpendicular to an underlying surfaced on which the vapor phase deposition layer is provided. As shown in Fig. 1, the thickness $d_{12}$ of the second vapor deposition layer 12 may quantify a distance between an upper interface and a lower interface of the second vapor deposition layer 12, wherein interfaces of the vapor phase deposition layers 11, 12 are shown as solid horizontal lines.

The thickness may refer to an average thickness of the vapor phase deposition layer. The average thickness may be determined over at least a portion of the underlying surface. A common technique to determine the average thickness of a vapor deposition layer is the so-called ball grinding method, wherein a ball such as a hardened steel ball with a precisely defined diameter is set into rotation, for example, by a motor-driven shaft. The ball is used to carry an abrasive slurry, such as diamond suspension or diamond paste. In this manner, a groove is ground into the coating, also referred to as a calotte. After grinding through the coating, each vapor deposition layer can be observed individually, for example, under the microscope as a concentric ring or ellipse. Since, compared to the coating thicknesses, the diameter of the ball is large, the vapor phase deposition layers are ground in a flat angle, such that the ring or ellipse of each vapor phase deposition layer has a width many times (e.g. 200 times) larger than the thickness of the respective vapor phase deposition layer. As the diameter of the ball is known, all layer thicknesses can then be calculated based on simple geometric relations.

Depending on the manufacturing process, a vapor deposition layer may provide as a sparse layer. In other words, the vapor deposition layer may comprise first regions in which a local thickness is greater than the average thickness and second regions in which a local thickness is less than the average thickness. Each of the first regions and second regions may be microscopic in size such that the underlying surface may be perceived to be approximately uniformly coated by the vapor phase deposition layer with a thickness corresponding to the average thickness.

The thickness may be adjusted by controlling an amount of material deposited on the underlying surface. The amount of material may be controlled by controlling a duration of the manufacturing process. As an example, a vapor phase deposition layer manufactured using a PVD process may have a thickness that is adjusted by controlling the duration of the PVD process.

The term color may refer to color as perceived by the human eye. A color of light may refer to a certain distribution (i.e. spectral density) of wavelengths in the visible spectrum, i.e. approximately between 380 nm to 750 nm. A color may be specified by its hue, saturation and luminance (or brightness). A commonly employed means for specifying color is based on the CIELAB color space having the coordinate axes L*, a* and b*. Here, a value of the coordinate axis L* represent a lightness ranging from black to white on a scale from 0 to 100, a value of the coordinate axis a* represents a position between magenta and green (where negative values indicate green and positive values indicate magenta), and a value of the coordinate axis b* represents a position between yellow and blue (where negative values indicate blue and positive values indicate yellow).

A color difference $\Delta E$ between two colors may be defined according to Equation 1, wherein $\Delta L*$, $\Delta a*$ and $\Delta b*$ refer to the differences in the L*, a* and b* values between the two colors.

$$\Delta E = \sqrt{\Delta L*^2 + \Delta a*^2 + \Delta b*^2} \qquad \text{[Equation 1]}$$

According to a recommendation provided by the ISO 15008 standard, two colors may be considered to be different (i.e. distinguishable) from each other if $\Delta E$ is greater than 20. For a particularly well-lit ambient, two colors may even be distinguishable at values of the color difference $\Delta E$ lower than 20. For a subpar-lit ambient, two colors may only be distinguishable at values of the color difference $\Delta E$ larger than 20.

A vapor phase deposition layer may reflect light of a certain color. As an example, a white light (e.g. daylight) shining on the vapor phase deposition layer may have a portion of the visible wavelengths of the white light reflected by vapor phase deposition layer while the rest of the visible wavelengths of the white light is not reflected, thereby producing a color different from white light.

One type of vapor phase deposition layers may generate the same color regardless of the thickness of the corresponding vapor phase deposition layer (e.g., TiCN). Vapor phase deposition layers of this type may be reflective in the visible spectrum. In this case, the color may result from interactions of light with free and bound electrons such that the color may be determined solely by an electronic band structure of the material of the vapor phase deposition layer (e.g. as indicated by a wavelength-dependent refractive index of the material). The color of light reflected by a phase deposition layer of this type may be referred to as intrinsic color.

Another type of vapor phase deposition layers may generate different colors depending on the thickness of the corresponding vapor phase deposition layer (e.g. most metal oxides). Vapor phase deposition layers of this other type may be at least semi-transparent (i.e. fully or partially transparent) in the visible spectrum. In this case, the color may be determined not only by an electronic band structure of the material but also by interference phenomena resulting from a geometry of the vapor phase deposition layer. The color of light reflected by a phase deposition layer of this other type may be referred to as interference-based color. Due to losses by absorption, a semi-transparent vapor phase deposition layer may reduce the brightness of transmitted light depending on its transmittance.

The interference phenomena may be described using thin-film interference theory. In short, electromagnetic waves reflected by the upper and lower interfaces of a thin film (e.g. of an at least semi-transparent vapor phase deposition layer) may interfere with each other. An optical path difference between the two reflected electromagnetic waves may depend on a thickness of the thin film and an angle of incidence. The angle of incidence is defined as the angle between a ray incident on a surface and the line perpendicular to said surface. Depending on the optical path difference, the two reflected electromagnetic waves may interfere constructively at some wavelengths and destructively at other wavelengths. For many materials compositions (e.g. AlTiN) of an at least semi-transparent vapor phase deposition layer, the colors of light reflected under different angles of incidence are not distinguishable.

As an example, a vapor phase deposition layers made from AlTiN provided on a stainless-steel substrate and having thicknesses varying from 35 nm to 55 nm will result in interference-based colors having hues varying from yellow, pink, violet to blue depending on the respective thickness (e.g. yellow for 35 nm and blue for 55 nm).

The first vapor phase deposition layer 11 may be reflective in the visible spectrum. In this case, the first color may be an intrinsic color. Alternatively, the first vapor phase deposition layer 11 may be at least semi-transparent in the visible spectrum. In this case, the first color may be an interference-based color. In other words, the first color may be produced based on interference of light reflected at interfaces of the first vapor phase deposition layer.

Regardless of the type of the first vapor phase deposition layer 11, the second vapor phase deposition layer 12 may be reflective in the visible spectrum. In this case, the second color may be an intrinsic color. The second vapor phase deposition layer 12 may be a sparse layer. In other words, the second vapor phase deposition layer 12 may be provided such as to coat the underlying surface (i.e. the first vapor deposition layer 11) only in first regions and not in second regions, wherein each of the first regions and second regions may be microscopic in size. In this manner, light reflected off the second vapor deposition layer 12 in the first region may have the first color, and light reflected off the first vapor deposition layer 11 in the second region not coated by the second vapor deposition layer 12 may have the second color. The first color and the second color may combine to produce the third color due to the first regions and second regions being microscopic in size, thereby resulting in a uniform appearance. By adjusting the (average) thickness $d_{12}$ of the second vapor deposition layer, the relative density of first regions may be increased, thereby increasing the contribution of the second color.

Alternatively, the second vapor phase deposition layer may be at least semi-transparent in the visible spectrum. In this case, the second color may be an interference-based color. In other words, the second color may be produced based on interference of light reflected at interfaces of the second vapor phase deposition layer.

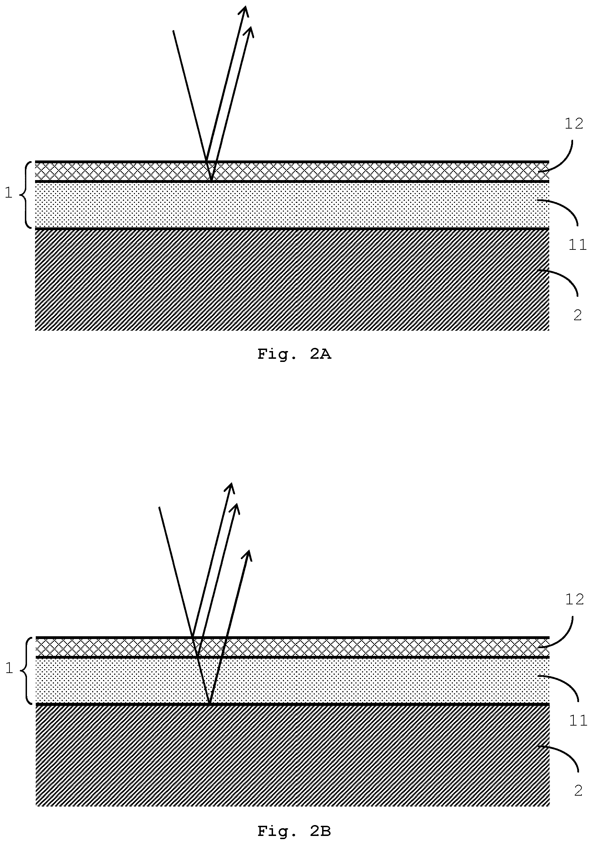

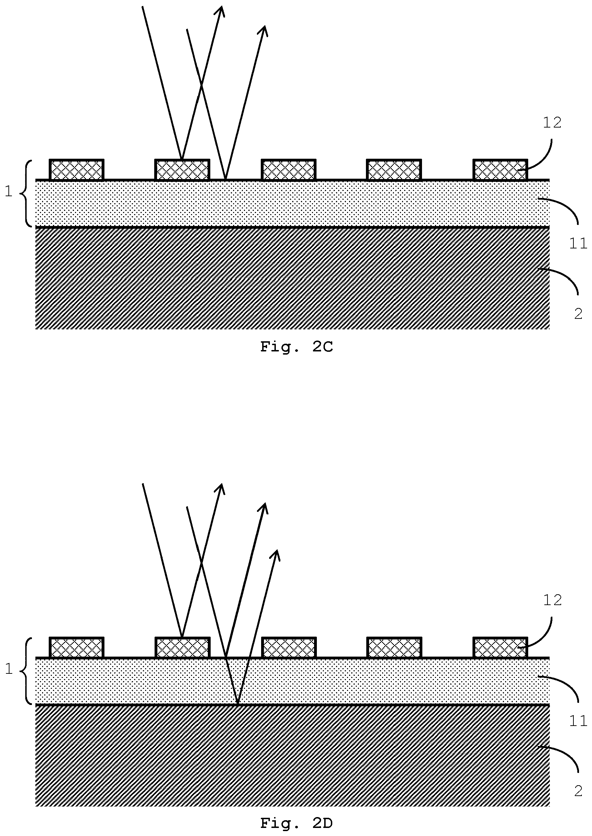

Fig. 2A shows an example of a coating 1 comprising a reflective first vapor phase deposition layer 11 and an at least semi-transparent second vapor phase deposition layer 12. Fig. 2B shows an example of a coating 1 comprising an at least semi-transparent first vapor phase deposition layer 11 and an at least semi-transparent second vapor phase deposition layer 12. Fig. 2C shows an example of a coating 1 comprising a reflective first vapor phase deposition layer 11 and a reflective second vapor phase deposition layer 12 provided as a sparse layer as described above. Fig. 2D shows an example of a coating 1 comprising an at least semi-transparent first vapor phase deposition layer 11 and a reflective second vapor phase deposition layer 12 provided as a sparse layer as described above. The arrows indicate reflected/-transmitted light rays (higher-order reflections are not shown).

The third color may be produced based on color mixing of the first color and the second color. In other words, the third color may correspond to a combination of the first color and the second color. The color mixing of the first color and the second color may be approximated by principles of subtractive color mixing. As an example, the third color may have a hue that is different from a hue of the first color and a hue of the second color (e.g. blue and yellow mixing to green). For a semi-transparent second vapor phase deposition layer, the third color may further be based on a transmittance of the second vapor phase deposition layer. In other words, due to losses by absorption, a semi-transparent vapor phase deposition layer may reduce the brightness of transmitted light depending on its transmittance.

As an example, the first color may have a blue hue, and the second color may have a yellow hue. Then, the first color and the second color may mix according to produce the third color. According to the present example, the third color may have a hue ranging from a light blue hue through a green hue to a dark yellow hue depending on the thickness of the second vapor phase deposition layer.

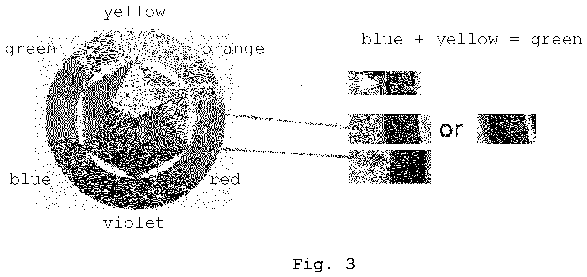

Fig. 3 shows an example of subtractive color mixing using substrates made from a metal. The bottom substrate has a single layer producing a first color having a blue hue. The top substrate has a single-layer coating producing a second color having a yellow hue. The two middle substrates each have a two-layer coating, wherein the lower layer (i.e. the first vapor phase deposition layer) produces a first color having a blue hue, and the upper layer (i.e. the second vapor phase deposition layer) produces a second color having a yellow hue, mixing together to produce a third color having a green hue. For the left one of the two middle substrates, the green hue has a slightly higher contribution of blue, due to a relatively small thickness (i.e. $d_{12}$) of the upper layer. Compared thereto, for the right one of the two middle substrates, the green hue has slightly higher contribution of yellow, due to a relatively large thickness (i.e. $d_{12}$) of the upper layer. For outdoor activity applications for example, such a green hue may provide equipment comprising either one of the two middle substrates with improved camouflage capability.

Each of the first vapor phase deposition layer and the second vapor phase deposition layer may have a material composition comprising one of Al, Cr, Ti, Zr, Hf, Si or a combination thereof. Alternatively, the material composition may comprise one of nitrides, carbides, oxides, carbonitrides, oxycarbides, oxynitrides, and oxycarbonitrides, or a combination thereof. As an example, the first vapor phase deposition layer may have a material composition of one of TiZr, TiZrN and TiZrON or may be a combination of two or more of TiZr, TiZrN, and TiZrON. The first vapor phase deposition layer preferably has a stepwise or a gradient material composition of TiZr/TiZrN/TiZrON. Other elements such as Niobium or Tantalum may be comprised in the material composition. As another example, the second vapor phase deposition layer may have a material composition of ZrON. According to a preferred embodiment, the first vapor phase deposition layer has a stepwise or a gradient material composition of TiZr/TiZrN/TiZrON and the second vapor phase deposition layer has a material composition of ZrON. As yet another example, the first vapor phase deposition layer may be an AlCr layer or an AlCrN layer.

As an example, a vapor phase deposition layer having a material composition of AlCr may reflect light with a color having a blue hue. As another example, a vapor phase deposition layer having a material composition of ZrON may reflect light with a color having a hue ranging from yellow to grey, i.e. gradually darkening, depending on the relative concentration x of oxygen ($O_2$) in the mixture of oxygen ($O_2$) and nitrogen ($N_2$) used to deposit the ZrON layer, expressed in % (= $O_2/(N_2 + O_2)$). For instance, the color may have a golden (yellow) hue for x = 10%, the color may have a bronze hue for x = 30%, and the color may have a graphite (grey) hue for x = 100%. Further information on such ZrON coatings synthesized by cathodic arc evaporation can be found in reference document [2], the contents of which are incorporated by reference herein.

Further examples for materials for providing a vapor deposition layer reflecting light with a color having a golden hue may be ZrN and TiN. Moreover, when adding carbon and therefore depositing ZrCN or TiCN, the contribution from the red hues may gradually increase as the carbon concentration increases, thereby turning the color of the light reflected by such a vapor deposition layer into a red gold and finally a copper color. At higher carbon content, both ZrCN and TiCN may produce a grey color.

As yet another example, a vapor deposition layer having a material composition of CrC can be used. Specifically, $CrC_x$ (with x being in the range of 0% to 100%) may reflect light with a grey color for a relative carbon content of x = 0%, with a grey/anthracite color for x = 50%, and with a deep black color for x = 100%. Here, the percentage x refers to the relative carbon content of the vapor deposition layer.

A substrate according to an embodiment may be any substrate having a coating according to the embodiments described above. The substrate may be made of one of a metal, an alloy, a ceramic, a glass, and a polymer. The substrate may be part of an article. In other words, an article according to an embodiment may be an article comprising a substrate according to the embodiments described above. As an example, the article may be a firearm, a tool, an automotive interior/exterior ornament, jewelry (e.g. a watch, a ring, eyeglass frames), a plumbing fixture, a door handle, a consumer electronic hardware (e.g. a smartphone), a sports equipment, and the like.

While various embodiments of the present disclosure have been described above, it should be understood that they have been presented by way of example, and not limitation. It will be apparent to persons skilled in the relevant art(s) that various changes in form and detail can be made therein. Thus, the above-described example embodiments are not limiting.

REFERENCE SIGNS

1      coating
2      substrate
11     first PVD layer
12     second PVD layer

**Claims**

1.  A coating for a substrate, the coating comprising:

    a first vapor phase deposition layer for depositing on the substrate, wherein the first vapor phase deposition layer reflects light having a first color; and

a second vapor phase deposition layer deposited on the first vapor phase deposition layer, wherein the second vapor phase deposition layer reflects light having a second color different from the first color;

wherein a thickness of the second vapor phase deposition layer is adjusted such that the coating reflects light having a third color different from the first color and the second color.

2. The coating according to claim 1, wherein the first vapor phase deposition layer is reflective in the visible spectrum.

3. The coating according to claims 1, wherein the first vapor phase deposition layer is at least semi-transparent in the visible spectrum.

4. The coating according to claim 3, wherein the first color is produced based on interference of light reflected at interfaces of the first vapor phase deposition layer.

5. The coating according to any one of claims 1 to 4, wherein the second vapor phase deposition layer is reflective in the visible spectrum.

6. The coating according to any one of claims 1 to 4, wherein the second vapor phase deposition layer is at least semi-transparent in the visible spectrum.

7. The coating according to claim 6, wherein the second color is produced based on interference of light reflected at interfaces of the second vapor phase deposition layer.

8. The coating according to any one of claims 1 to 7, wherein the third color is produced based on color mixing of the first color and the second color.

9. The coating according to claim 8, wherein

the first color has a blue hue, and
the second color has a yellow hue.

10. The coating according to claim 9, wherein the third color has a hue ranging from a light blue hue through a green hue to a dark yellow hue depending on the thickness of the second vapor phase deposition layer.

11. The coating according to any one of claims 1 to 10, wherein the first vapor phase deposition layer has a material composition of one of TiZr, TiZrN and TiZrON or is a combination of two or more of TiZr, TiZrN, and TiZrON; or wherein the first vapor phase deposition layer is an AlCr layer or an AlCrN layer.

12. The coating according to any one of claims 1 to 11, wherein the second vapor phase deposition layer has a material composition of ZrON.

13. A substrate having a coating according to any one of claims 1 to 12.

14. The substrate according to claim 13, wherein the substrate is made of one of a metal, an alloy, a ceramic, a glass, and a polymer.

15. An article comprising a substrate according to any one of claims 13 to 14.

Fig. 1

Fig. 2A

Fig. 2B

Fig. 2C

Fig. 2D

Fig. 3

Europäisches
Patentamt

European
Patent Office

Office européen
des brevets

# EUROPEAN SEARCH REPORT

**Application Number**

EP 24 17 1584

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 0 890 659 A2 (MASCO CORP [US]) 13 January 1999 (1999-01-13) * column 10, line 53 - column 13, line 31; figure 4 * | 1-15 | INV. C23C14/00 C23C14/06 C23C14/14 C23C16/00 |
| X | US 6 218 018 B1 (MCKOWN CLEM [US] ET AL) 17 April 2001 (2001-04-17) * column 5, line 55 - line 57; claims 1, 9-12; figures 1, 2 * * column 7, line 57 - line 60 * | 1-15 | C23C16/06 C23C16/30 C23C28/02 C23C28/04 C23C28/00 |
| X | US 2018/244568 A1 (YOU HYUN-WOO [KR] ET AL) 30 August 2018 (2018-08-30) * paragraphs [0042] - [0044], [0052], [0053], [0060], [0062]; claims 1-4; figure 1 * | 1-15 | |

**TECHNICAL FIELDS SEARCHED    (IPC)**

C23C

The present search report has been drawn up for all claims

| Place of search | Date of completion of the search | Examiner |
|---|---|---|
| The Hague | 23 October 2024 | Engelen, Karen |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 24 17 1584

This annex lists the patent family members relating to the patent documents cited in the above-mentioned European search report.
The members are as contained in the European Patent Office EDP file on
The European Patent Office is in no way liable for these particulars which are merely given for the purpose of information.

23-10-2024

| Patent document cited in search report | | Publication date | Patent family member(s) | | Publication date |
|---|---|---|---|---|---|
| EP 0890659 | A2 | 13-01-1999 | AU | 727578 B2 | 14-12-2000 |
| | | | CA | 2242619 A1 | 09-01-1999 |
| | | | CN | 1216325 A | 12-05-1999 |
| | | | DE | 69811998 T2 | 08-01-2004 |
| | | | EP | 0890659 A2 | 13-01-1999 |
| | | | FR | 2765893 A1 | 15-01-1999 |
| | | | GB | 2327091 A | 13-01-1999 |
| | | | JP | H11140664 A | 25-05-1999 |
| | | | KR | 19990013700 A | 25-02-1999 |
| | | | RU | 2171316 C2 | 27-07-2001 |
| | | | TW | 490507 B | 11-06-2002 |
| | | | US | 5879532 A | 09-03-1999 |
| | | | US | 6221231 B1 | 24-04-2001 |
| | | | US | 2001001436 A1 | 24-05-2001 |
| US 6218018 | B1 | 17-04-2001 | BR | 9904556 A | 05-09-2000 |
| | | | CN | 1263874 A | 23-08-2000 |
| | | | EA | 199900671 A2 | 28-02-2000 |
| | | | EG | 21696 A | 27-02-2002 |
| | | | EP | 0983972 A2 | 08-03-2000 |
| | | | IL | 131253 A | 28-03-2004 |
| | | | JP | 4538116 B2 | 08-09-2010 |
| | | | JP | 2000103648 A | 11-04-2000 |
| | | | KR | 20000017438 A | 25-03-2000 |
| | | | NZ | 337160 A | 29-09-2000 |
| | | | PL | 335017 A1 | 28-02-2000 |
| | | | SK | 113799 A3 | 12-06-2000 |
| | | | TR | 199901995 A2 | 21-09-2001 |
| | | | US | 6218018 B1 | 17-04-2001 |
| US 2018244568 | A1 | 30-08-2018 | CN | 108026752 A | 11-05-2018 |
| | | | EP | 3351717 A1 | 25-07-2018 |
| | | | KR | 20170032530 A | 23-03-2017 |
| | | | US | 2018244568 A1 | 30-08-2018 |
| | | | WO | 2017047983 A1 | 23-03-2017 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 217651304 U
- CN 106381473 A
- CN 102114720 A
- CN 1502430 A

- US 6586114 B1
- EP 0890659 A2
- WO 2014116967 A1

**Non-patent literature cited in the description**

- **TAREK, AHMAD HJ et al.** Physical Vapour Deposition of Zr-Based Nano Films on Various Substrates: A Review.. *Current Nanoscience*, 2022, vol. 18.3, 347-366
- **KUPRIN, ALEXANDER S. et al.** Structure and properties of ZrON coatings synthesized by cathodic arc evaporation.. *Materials*, 2021, vol. 14.6, 1483

- **PERKINS, JOSHUA et al.** Color Tunable, Lithography-Free Refractory Metal-Oxide Metacoatings with a Graded Refractive Index Profile.. *Nano Letters*, 2023, vol. 23.7, 2601-2606